# EUROPEAN PATENT APPLICATION

(11) **EP 4 311 844 A1**
(43) Date of publication of application: **31.01.2024**
(21) Application number: 22779458.3
(22) Date of filing: 26.01.2022
(51) Int. Cl.: C08L 101/00, H01L 21/20, H01L 21/225, H01L 21/228, C08K 3/01, C08K 3/08, C08K 3/34

(54) **PASTE COMPOSITION, AND METHOD FOR FORMING GERMANIUM COMPOUND LAYER**

(30) Priority: 31.03.2021 JP 2021061002
(71) Applicant: Toyo Aluminium Kabushiki Kaisha, Osaka-shi, Osaka 541-0056 (JP)
(72) Inventor: DHAMRIN, Marwan, Osaka-shi, Osaka 541-0056 (JP); SUZUKI, Shota, Osaka-shi, Osaka 541-0056 (JP)
(74) Representative: Marks & Clerk LLP
(86) International application number: PCT/JP2022/002850
(87) International publication number: WO 2022/209228

(57) **Abstract**

The present invention provides a paste composition that is capable of forming a germanium compound layer on a germanium substrate safely and easily, and that is capable of forming a uniform germanium compound layer. The paste composition for forming a germanium compound layer contains (A) tin and (B) at least one metal selected from the group consisting of silicon and aluminum, wherein the content of the at least one metal selected from the group consisting of silicon and aluminum (B) is 1 part by mass or more and 15000 parts by mass or less, per 100 parts by mass of the tin (A).

## Description

### Technical Field

The present invention relates to a paste composition and a method for forming a germanium compound layer.

### Background Art

Silicon germanium (Si-Ge), which is a mixed crystalline material of silicon and germanium, has been used as a semiconductor material. Such a semiconductor material is formed as a silicon-germanium layer on a substrate such as silicon and used as part of a transistor or a diode.

Studies disclose the following methods for forming a silicon-germanium layer: a method of performing epitaxial growth by chemical vapor deposition (CVD) (see PTL 1), a method of performing epitaxial growth by molecular beam epitaxy (MBE) (see PTL 2), and a method of forming a film by sputtering using an Si-Ge-based compound target (see PTL 3).

However, lately, germanium substrates are sometimes used as a substrate for forming a semiconductor material containing a germanium compound layer such as the silicon-germanium layer described above. Thus, there is demand for a method for forming a germanium compound layer on a germanium substrate.

Although PTL 1 and PTL 2 disclose methods for forming a silicon-germanium layer, these methods require the use of a hazardous gas, such as SiH₄ or GeH₄. Thus, there is demand for a method for safely forming a germanium compound layer by using a germanium substrate without using highly hazardous gases.

The methods disclosed in PTL 1 to PTL 3 also take a long period of time in the processes of performing epitaxial growth and of forming a film by sputtering because of the need for a vacuum apparatus.

A study discloses a method for forming a silicon-germanium layer without the processes of performing epitaxial growth and of forming a film by sputtering (see PTL 4). Although this method is also excellent, forming a uniform germanium compound layer has yet to be considered. When a paste composition containing aluminum and germanium is applied to and heated on a silicon substrate, the germanium compound layer formed on the silicon substrate may become a thin and non-uniform layer. Semiconductors formed by using a non-uniform germanium compound layer are unsatisfactory in performance and not suitable for use in semiconductors.

Thus, there is demand for the development of a method for forming a germanium compound layer that is capable of forming a germanium compound layer on a germanium substrate safely and easily, and that is capable of forming a uniform germanium compound layer. There is also demand for the development of a paste composition for use in the method for forming a germanium compound layer.

### Citation List

### Patent Literature

PTL 1: JP2011-146684A
PTL 2: JP2004-172276A
PTL 3: JP2004-018946A
PTL 4: WO2017/051775A

### Summary of Invention

### Technical Problem

An object of the present invention is to provide a paste composition that is capable of forming a germanium compound layer on a germanium substrate safely and easily, and that is capable of forming a uniform germanium compound layer. Another object of the invention is to provide a method capable of forming a germanium compound layer on a germanium substrate safely and easily, and forming a uniform germanium compound layer.

### Solution to Problem

As a result of intensive research to achieve the objects above, the present inventors found that the objects can be achieved by a paste composition that contains (A) tin and (B) at least one metal selected from the group consisting of silicon and aluminum, wherein the content of the at least one metal selected from the group consisting of silicon and aluminum (B) is within a specific range relative to the tin (A). The inventors then completed the present invention.

Specifically, the present invention relates to the following paste composition and method for forming a germanium compound layer.
1. A paste composition for forming a germanium compound layer, comprising
   (A) tin, and
   (B) at least one metal selected from the group consisting of silicon and aluminum,
   wherein the content of the at least one metal selected from the group consisting of silicon and aluminum (B) is 1 part by mass or more and 15000 parts by mass or less, per 100 parts by mass of the tin (A).
2. The paste composition according to Item 1, wherein the content of the at least one metal selected from the group consisting of silicon and aluminum (B) is 40 parts by mass or more and 300 parts by mass or less, per 100 parts by mass of the tin (A).
3. The paste composition according to Item 1 or 2, further comprising a resin component.
4. The paste composition according to Item 3, wherein the content of the resin component is 0.1 to 10 parts by mass, per 100 parts by mass of the total amount of the tin (A) and the at least one metal selected from the group consisting of silicon and aluminum (B) .
5. A method for forming a germanium compound layer, comprising
   (1) step 1 of applying a paste composition to a germanium substrate, and
   (2) step 2 of firing the germanium substrate coated with the paste composition,
   wherein
   the paste composition contains (A) tin, and (B) at least one metal selected from the group consisting of silicon and aluminum, and
   the content of the at least one metal selected from the group consisting of silicon and aluminum (B) is 1 part by mass or more and 15000 parts by mass or less, per 100 parts by mass of the tin (A).
6. The method according to Item 5, wherein the firing temperature in the firing is 600°C or higher and 1000°C or lower.

### Advantageous Effects of Invention

The paste composition according to the present invention forms a germanium compound layer safely and easily, and forms a uniform germanium compound layer when applied to a germanium substrate and heated.

The method for forming a germanium compound layer according to the present invention enables the formation of a germanium compound layer by applying a paste composition to a germanium substrate and heating the paste composition; thus, the method forms a germanium compound layer safely and easily and forms a uniform germanium compound layer.

### Brief Description of Drawings

Fig. 1 shows an SEM image of a cross-section of the germanium compound layer formed in Example 1.
Fig. 2 shows a Ge element mapping image of a cross-section of the germanium compound layer formed in Example 1.
Fig. 3 shows an Si element mapping image of a cross-section of the germanium compound layer formed in Example 1.
Fig. 4 shows an SEM image of a cross-section of the germanium compound layer formed in Example 2.
Fig. 5 shows an SEM image of a cross-section of the germanium compound layer formed in Example 3.
Fig. 6 shows an SEM image of the cross-section formed in Comparative Example 4.
Fig. 7 shows a Ge element mapping image of the cross-section formed in Comparative Example 4.
Fig. 8 shows an Si element mapping image of the cross-section formed in Comparative Example 4.

### Description of Embodiments

The paste composition according to the present invention is a paste composition for forming a germanium compound layer, and contains (A) tin and (B) at least one metal selected from the group consisting of silicon and aluminum, wherein the content of the at least one metal selected from the group consisting of silicon and aluminum (B) is 1 part by mass or more and 15000 parts by mass or less, per 100 parts by mass of the tin (A) .

Due to the configuration described above, when the paste composition according to the present invention is applied to a germanium substrate containing germanium such as a germanium wafer by a coating method such as screen printing, and is heated, germanium contained in the germanium substrate and (A) tin and (B) at least one metal selected from the group consisting of silicon and aluminum in the paste composition form an alloy. As the temperature decreases after the completion of heating, the alloy is recrystallized, and a germanium compound layer is formed on the germanium substrate. Because a germanium compound layer can be formed by applying the paste composition according to the present invention to a germanium substrate and heating it, it is unnecessary to use a hazardous gas such as SiH₄ or GeH₄, and to use equipment such as a vacuum apparatus. Thus, a germanium compound layer can be formed safely and easily without taking a long time. The paste composition according to the present invention can also form a germanium compound layer of sufficient thickness to thereby give a uniform germanium compound layer.

If the paste composition according to the present invention contains tin and silicon, a silicon-tin-germanium compound layer is formed as the germanium compound layer. If the paste composition according to the present invention contains aluminum and tin, a tin-germanium compound layer is formed as the germanium compound layer. If the paste composition according to the present invention contains aluminum, silicon, and tin, a silicon-tin-germanium compound layer is formed as the germanium compound layer.

The following describes in more detail the paste composition and the method for forming a germanium compound layer according to the present invention.

### 1. Paste Composition

The paste composition according to the present invention is a paste composition for forming a germanium compound layer, and contains (A) tin ("component (A)" below) and (B) at least one metal selected from the group consisting of silicon and aluminum ("component (B)" below), wherein the content of the at least one metal selected from the group consisting of silicon and aluminum (B) is 1 part by mass or more and 15000 parts by mass or less, per 100 parts by mass of the tin (A).

The content of component (B) in the paste composition is 1 part by mass or more and 15000 parts by mass or less per 100 parts by mass of component (A). A content of component (B) falling outside the above range may result in decreased reactivity of tin, silicon and/or aluminum, and germanium, and may thus lead to failure to sufficiently form a germanium compound layer. The content of component (B) is preferably 14000 parts by mass or less, more preferably 11000 parts by mass or less, still more preferably 5000 parts by mass or less, particularly preferably 1000 parts by mass or less, and most preferably 300 parts by mass or less. The content of component (B) is preferably 40 parts by mass or more, more preferably 100 parts by mass or more, and still more preferably 200 parts by mass or more.

### Tin

The tin is not particularly limited as long as it is in a form that can be contained in the paste composition; examples include a tin powder.

The tin powder preferably has a tin purity of 95.0 mass% or higher, and more preferably 99.0 mass% or higher. The tin powder may be a tin alloy powder containing other metals in addition to tin. Examples of tin alloy powders include powdery alloys containing at least one element selected from the group consisting of iron, copper, manganese, magnesium, chromium, zinc, titanium, vanadium, gallium, nickel, boron, and zirconium. The content of each of these elements is preferably 1000 ppm by mass or less, particularly preferably 300 ppm by mass or less, based on the total amount of the tin alloy powder.

The shape of the tin powder is not particularly limited. The tin powder may be of any shape, such as a spherical, elliptical, irregular, flakey, or fibrous shape. Of these, a spherical shape is preferable from the viewpoint of good printability and excellent reactivity with germanium.

The average particle size (D₅₀) of the tin powder is preferably 1 to 30 pm, more preferably 1 to 15 pm, and still more preferably 3 to 8 um. An average particle size of the tin powder within the above ranges leads to better reactivity of the tin powder with germanium and improved printability of the paste composition.

The content of tin in the paste composition of the present invention is preferably 0.5 to 99 mass%, and more preferably 10 to 50 mass%, based on 100 mass% of the paste composition. A lower limit of the tin content within the above ranges leads to further improved reactivity of tin and germanium, thus making it easier to form a germanium alloy layer. An upper limit of the tin content within the above ranges leads to further improved uniformity of the thickness of the germanium alloy layer.

### Silicon

The silicon is not particularly limited as long as it is in a form that can be contained in the paste composition;

### examples include a silicon powder.

The silicon powder preferably has a silicon purity of 98.0 mass% or higher, and more preferably 99.0 mass% or higher. The silicon powder may be a silicon alloy powder containing other metals in addition to silicon. Examples of silicon alloy powders include powdery alloys containing at least one element selected from the group consisting of iron, copper, manganese, magnesium, chromium, zinc, titanium, vanadium, gallium, nickel, boron, and zirconium. The content of each of these elements is preferably 1000 ppm by mass or less, particularly preferably 300 ppm by mass or less, based on the total amount of the silicon alloy powder.

The shape of the silicon powder is not particularly limited. The silicon powder may be of any shape, such as a spherical, elliptical, irregular, flakey, or fibrous shape. Of these, a spherical shape is preferable from the viewpoint of good printability and excellent reactivity with germanium.

The average particle size (D₅₀) of the silicon powder is preferably 1 to 20 pm, more preferably 1 to 10 pm, and still more preferably 1 to 5 um. An average particle size of the silicon powder within the above ranges leads to better reactivity of the silicon powder with germanium and improved printability of the paste composition.

When the paste composition of the present invention contains silicon, the content of silicon is preferably 1 part by mass or more, more preferably 20 parts by mass or more, still more preferably 40 parts by mass or more, particularly preferably 80 parts by mass or more, and most preferably 100 parts by mass or more, per 100 parts by mass of tin. The content of silicon is preferably 10000 parts by mass or less, more preferably 5000 parts by mass or less, still more preferably 1000 parts by mass or less, particularly preferably 500 parts by mass or less, and most preferably 300 parts by mass or less, per 100 parts by mass of tin. A lower limit of the silicon content within the above ranges makes it much easier to form a silicon-germanium layer as a germanium alloy layer. An upper limit of the silicon content within the above ranges leads to further improved reactivity of tin with germanium.

### Aluminum

The aluminum is not particularly limited as long as it is in a form that can be contained in the paste composition; examples include an aluminum powder.

The aluminum powder preferably has an aluminum content of 99.0 mass% or higher, and more preferably 99.9 mass% or higher. The aluminum powder may be an aluminum alloy powder containing other metals in addition to aluminum. Examples of aluminum alloy powders include powdery alloys containing at least one element selected from the group consisting of iron, copper, manganese, magnesium, chromium, zinc, titanium, vanadium, gallium, nickel, boron, and zirconium. The content of each of these elements is preferably 1000 ppm by mass or less, particularly preferably 300 ppm by mass or less, based on the total amount of the aluminum alloy powder.

The shape of the aluminum powder is not particularly limited. The aluminum powder may be of any shape, such as a spherical, elliptical, irregular, flaky, or fibrous shape. Of these, a spherical shape is preferable from the viewpoint of good printability and excellent reactivity with silicon.

The average particle size (D₅₀) of the aluminum powder is preferably 1 to 20 pm, more preferably 1 to 10 pm, and still more preferably 1 to 5 um. An average particle size of the aluminum powder within the above ranges lead to better reactivity of the aluminum powder with germanium and improved printability of the paste composition.

In this specification, the average particle size (D₅₀) indicates a value measured according to laser diffractometry. Specifically, the average particle size indicates the particle size of the particles corresponding to 50% of the total number of particles in a particle size distribution curve determined by finding a particle size and the number of particles having the particle size.

When the paste composition of the present invention contains aluminum, the content of aluminum is preferably 1 part by mass or more, more preferably 20 parts by mass or more, still more preferably 40 parts by mass or more, particularly preferably 80 parts by mass or more, and most preferably 100 parts by mass or more, per 100 parts by mass of tin. The content of aluminum is preferably 10000 parts by mass or less, more preferably 8000 parts by mass or less, still more preferably 5000 parts by mass or less, particularly preferably 1000 parts by mass or less, and most preferably 500 parts by mass or less, per 100 parts by mass of tin. An aluminum content within the above ranges leads to better reactivity of aluminum with germanium, thereby further improving the reactivity of tin with germanium and making it easier to form a germanium alloy layer.

For aluminum to be contained in the paste composition of the present invention, an aluminum-tin alloy may be used. The aluminum-tin alloy is not particularly limited as long as it is in a form that can be contained in the paste composition; for example, an aluminum-tin alloy powder may be used.

When an aluminum-tin alloy is used, the tin content and the aluminum content in the paste composition are the same as the tin content and the aluminum content described above. The shape and average particle size of the aluminum-tin alloy powder are the same as the shape and average particle size of the aluminum powder or tin powder described above.

For silicon and aluminum to be contained in the paste composition of the present invention, an aluminum-silicon alloy may be used. The aluminum-silicon alloy is not particularly limited as long as it is in a form that can be contained in the paste composition; for example, an aluminum-silicon alloy powder may be used.

When an aluminum-silicon alloy is used, the aluminum content and the silicon content in the paste composition are the same as the aluminum content and the silicon content described above. The shape and average particle size of the aluminum-silicon alloy powder are the same as the shape and average particle size of the aluminum powder or silicon powder described above.

For tin, silicon, and aluminum to be contained in the paste composition of the present invention, an aluminum-silicon-tin alloy may be used. The aluminum-silicon-tin alloy is not particularly limited as long as it is in a form that can be contained in the paste composition; for example, an aluminum-silicon-tin alloy powder may be used.

When an aluminum-silicon-tin alloy is used, the aluminum content, silicon content, and tin content in the paste composition are respectively the same as the aluminum content, silicon content, and tin content described above. The shape and average particle size of the aluminum-silicon-tin alloy powder are the same as the shape and average particle size of the aluminum powder, silicon powder, or tin powder described above.

The aluminum powder, silicon powder, tin powder, aluminum-silicon alloy powder, aluminum-tin alloy powder, and aluminum-silicon-tin powder may be used alone, or in a combination of two or more.

### Glass Component

The paste composition of the present invention may contain a glass component. A glass powder contained in the paste composition provides better reactivity between aluminum and germanium, and thereby improves the reactivity of silicon and tin with germanium, making it easier to form a germanium alloy layer.

The glass component preferably contains at least one of the following: an alkali metal and an alkaline earth metal. Specifically, the glass component preferably contains at least one oxide of the following: lithium, sodium, and potassium, which belong to alkali metals; and calcium, magnesium, strontium, and barium, which belong to alkaline earth metals. The glass component may also contain one, or two or more selected from the group consisting of Pb, Bi, V, B, Si, Sn, P, and Zn. Additionally, usable glass components include lead-containing glass components and lead-free glass components such as those containing bismuth, vanadium, tin-phosphorus, zinc borosilicate, or alkali borosilicate. The glass component preferably contains a B₂O₃ component or a PbO component. In particular, in view of the effects on human health, a lead-free glass component is preferable for use.

The glass component preferably has a softening point of 300 to 700°C, and more preferably 400 to 600°C. A softening point of the glass component within the above ranges further accelerates the reaction of tin, aluminum, and silicon with germanium, thus making it easier to form a germanium compound layer.

The glass component is not particularly limited as long as it is in a form that can be contained in the paste composition; examples include a glass powder. The average particle size of the glass powder is preferably 1 to 8 µm, and more preferably 2 to 4 µm. A lower limit of the average particle size of the glass powder within the above ranges leads to limited agglomeration of the glass powder during paste dispersion. An upper limit of the average particle size of the glass powder within the above ranges leads to further improved formation of a germanium compound layer.

The content of the glass component is not particularly limited. The content of the glass component is preferably 0.1 to 5 parts by mass, and more preferably 0.1 to 3 parts by mass, per 100 parts by mass of the total amount of (A) tin and (B) at least one metal selected from the group consisting of silicon and aluminum. A glass component content within the ranges above leads to better reactivity of tin, aluminum, and silicon with germanium, and makes it easier to form a germanium compound layer.

### Resin Component

The paste composition of the present invention may contain a resin component. A resin component contained in the paste composition can improve the stability and printability of the paste composition.

The resin for use in the resin component is not particularly limited and may be conventionally known resins. Examples of such resins include ethyl cellulose, nitrocellulose, polyvinyl butyral, phenol resins, melanin resins, urea resins, xylene resins, alkyd resins, unsaturated polyester resins, acrylic resins, polyimide resins, furan resins, urethane resins, isocyanate compounds, cyanate compounds, and like thermosetting resins; and polyethylene, polypropylene, polystyrene, ABS resins, polymethyl methacrylate, polyvinyl chloride, polyvinylidene chloride, polyvinyl acetate, polyvinyl alcohol, polyacetal, polycarbonate, polyethylene terephthalate, polybutylene terephthalate, polyphenylene oxide, polysulfone, polyimide, polyether sulfone, polyarylate, polyether ether ketone, polytetrafluoroethylene, and silicone resins. Of these, ethyl cellulose is preferred from the viewpoint of higher stability and printability of the paste composition. These resins may be used alone, or in a combination of two or more.

The resin component preferably has a melting point of 100 to 300°C, and more preferably 150 to 300°C. A melting point of the resin component within the above ranges accelerates the reaction of aluminum with germanium and thereby improves the reactivity of silicon and tin with germanium, thus making it easier to form a germanium compound layer.

The content of the resin component is not particularly limited. The content of the resin component is preferably 0.1 to 10 parts by mass, more preferably 0.1 to 8 parts by mass, and still more preferably 0.5 to 7.5 parts by mass, per 100 parts by mass of the total amount of components (A) and (B). A resin component content within the above ranges leads to improved stability and printability of the paste composition.

### Dispersion Medium

The paste composition of the present invention may contain a dispersion medium. A dispersion medium contained in the paste composition improves the printability of the paste composition.

The dispersion medium is not particularly limited as long as the dispersion medium can disperse aluminum and at least one metal selected from the group consisting of silicon and tin; for example, the dispersion medium for use can be water or a solvent. The paste composition of the present invention may be in a form in which aluminum and at least one metal selected from the group consisting of silicon and tin are dispersed in water and/or a solvent; or may be in a form of composition containing aluminum, at least one metal selected from the group consisting of silicon and tin, and an organic vehicle obtained by dissolving a resin component in a solvent.

The solvent for use can be a known solvent, specifically including diethylene glycol monobutyl ether, diethylene glycol monobutyl ether acetate, dipropylene glycol monomethyl ether, and terpineols. Of these, diethylene glycol monobutyl ether and terpineols are preferred from the viewpoint of dispersibility and printability.

These dispersion media may be used alone, or in a combination of two or more.

The content of the dispersion medium is not particularly limited. The content of the dispersion medium is preferably 0.1 to 50 parts by mass, more preferably 0.5 to 30 parts by mass, and still more preferably 2 to 30 parts by mass, per 100 parts by mass of the total amount of components (A) and (B). A resin component content within the above ranges leads to improved stability and printability of the paste composition.

### Other Additives

The paste composition of the present invention may contain other additives in addition to aluminum, at least one metal selected from the group consisting of silicon and tin, a glass component, a resin component, and a dispersion medium. Such additives are not particularly limited as long as the effects of the present invention are not impaired. Examples include antioxidants, corrosion inhibitors, antifoaming agents, thickening agents (tackifiers), coupling agents, electrostatic-imparting agents, polymerization inhibitors, thixotropic agents, and anti-settling agents. Specifically, additives for use include, for example, a polyethylene glycol ester compound, a polyoxyethylene sorbitan ester compound, a sorbitan alkyl ester compound, an aliphatic polyvalent carboxylic acid compound, a phosphoric acid ester compound, an amide amine salt of a polyester acid, a polyethylene oxide compound, and fatty acid amide wax.

The content of the other additional additives is not particularly limited; the content of each additive is preferably about 0.01 to 2 parts by mass, per 100 parts by mass of aluminum.

The paste composition of the present invention preferably has a viscosity of 5 to 100 Pa·s, and more preferably 10 to 40 Pa·s. A paste composition with a viscosity within the above ranges has excellent printability. In the present specification, the viscosity is a value measured by using a rotational viscometer (DV2T, Brookfield Corporation) with a CP-51 spindle at a rotation speed of 2.5 rpm.

The method for producing the paste composition of the present invention is not particularly limited. The individual components may be mixed with stirring according to a conventionally known method. For example, the paste composition of the present invention can be produced by a production method including adding (A) tin and (B) at least one metal selected from the group consisting of silicon and aluminum to the dispersion medium described above, optionally adding a glass component, a resin component, and other additives, and mixing them with stirring at room temperature.

### 2. Method of Forming Germanium Compound Layer

The method according to the present invention is a method for forming a germanium compound layer, comprising
(1) step 1 of applying a paste composition to a germanium substrate, and
(2) step 2 of firing the germanium substrate coated with the paste composition,
wherein
the paste composition contains (A) tin, and (B) at least one metal selected from the group consisting of silicon and aluminum, and
the content of the at least one metal selected from the group consisting of silicon and aluminum (B) is 1 part by mass or more and 15000 parts by mass or less, per 100 parts by mass of the tin (A).

The method is described in detail below.

### Step 1

Step 1 is a step of applying a paste composition to a germanium substrate.

The paste composition for use can be the paste composition described above.

The germanium substrate is not particularly limited as long as it contains germanium. For example, a germanium substrate for use is one obtained by slicing a germanium ingot. The germanium substrate preferably has a germanium content of 99.0 mass% or higher, and more preferably 99.99 mass% or higher.

The germanium substrate may contain elements other than germanium as impurities or additives. Examples of such other elements include boron, phosphorus, gallium, and aluminum, which are dopants of semiconductors; and oxygen, nitrogen, carbon, iron, etc., which are included in the manufacturing process of a germanium ingot. The concentration of each of such elements is preferably 100 ppm or less.

The thickness of the germanium substrate is preferably 50 to 1000 µm, and more preferably 150 to 700 µm.

The method for applying a paste composition to a germanium substrate is not particularly limited. Examples include coating methods such as spin coating and ink jet printing. Examples of coating methods further include dip coating and known roll coating methods. Specific examples include air doctor coating, blade coating, rod coating, extrusion coating, air knife coating, squeeze coating, impregnation coating, reverse roll coating, transfer roll coating, gravure coating, kiss coating, cast coating, and spray coating. Examples of coating methods further include printing methods such as intaglio printing in which the optimum viscosity range is in a relatively low viscosity range, and printing methods such as screen printing in which the optimum viscosity range is in a relatively high viscosity range. Specific examples include stencil printing, intaglio printing, and planographic printing.

The amount of the paste composition applied to the germanium substrate is preferably 4 to 12 mg/cm², and more preferably 6 to 8 mg/cm². A lower limit of the amount of the applied paste composition within the above ranges leads to further improved uniformity of the formed germanium compound layer. An upper limit of the amount of the applied paste composition within the above ranges allows for firing in a short time and thus leads to further improved uniformity of the formed germanium compound layer.

Additionally, the amount of solids of the paste composition applied to the germanium substrate is preferably 3 mg/cm² or more and 9 mg/cm² or less in total of component (A) and component (B). When the paste composition contains a glass powder, the amount of solids of the applied paste composition is preferably 3 mg/cm² or more and 9.5 mg/cm² or less in total of component (A), component, (B), and the glass powder. An amount of solids of the applied paste composition within the above ranges leads to further uniform distribution of heat in the firing step and further uniform reaction with the germanium substrate.

In step 1 as described above, the paste composition is applied to the germanium substrate.

### Step 2

Step 2 is a step of firing the germanium substrate coated with the paste composition.

The firing conditions are not limited. The firing can be performed in an air atmosphere or an inert gas atmosphere such as nitrogen.

The firing temperature is more preferably 600 to 1000°C, and still more preferably 850 to 950°C. Firing at a firing temperature within the above range allows for more sufficient formation of the germanium compound layer.

The firing time is preferably 3 to 600 seconds, and more preferably 5 to 300 seconds. A firing time within the above ranges allows for the formation of a germanium compound layer with increased uniformity. The firing time may be adjusted according to the firing temperature. However, it is preferable to raise the firing temperature to shorten the firing time from the viewpoint of excellent production efficiency.

Because of the use of a vacuum apparatus in CVD growth or sputtering, conventional techniques take 5 minutes or more in a vacuum evacuation step, and further require a film-forming step taking several minutes to several hours, in order to form a germanium compound layer, depending on the thickness of the film to be formed. However, the method for forming a germanium compound layer of the present invention does not use a vacuum apparatus, and allows a germanium compound layer to form in the firing time within the above ranges.

In step 2 as described above, the germanium substrate coated with the paste composition is fired.

The forming method of the present invention may include a cooling step after step 2. The cooling method is not particularly limited. Examples include a method of leaving the fired germanium substrate coated with the paste composition at room temperature to slowly cool it (i.e., a cooling method by air cooling). The fired germanium substrate coated with the paste composition may also be cooled with a cooling device. After firing in step 2, the alloy recrystallizes as the temperature of the substrate decreases, and a germanium compound layer forms on the germanium substrate. The cooling rate for cooling is preferably 1 to 30°C/s, more preferably 10 to 30°C/s, and still more preferably 20 to 30°C/s.

### Preheating Step

The method for forming a germanium compound layer of the present invention may include a preheating step of removing the resin component and other components from the paste composition applied to the germanium substrate between step 1 and step 2. Because the preheating step removes the resin component present in the paste composition and simultaneously removes the dispersion medium, the preheating step allows for more sufficient formation of the germanium compound layer.

The preheating conditions are not limited. However, it is preferable to perform preheating according a conventional known method in an air atmosphere or an inert gas atmosphere such as nitrogen.

The preheating temperature is preferably 300 to 500°C, and more preferably 400 to 500°C. The preheating time is preferably 20 to 600 seconds, and more preferably 20 to 60 seconds.

### Drying Step

The method for forming a germanium compound layer of the present invention may include a drying step of drying the paste composition applied to the germanium substrate before the preheating step. The drying step removes the dispersion medium present in the paste composition to some extent beforehand, thus allowing for more sufficient formation of a germanium compound layer.

The drying conditions are not limited. However, it is preferable to perform drying by heating according a conventional known method in an air atmosphere or an inert gas atmosphere such as nitrogen.

The drying temperature is preferably 100 to 400°C, and more preferably 100 to 200°C. The drying time is preferably 20 to 600 seconds, and more preferably 60 to 300 seconds.

### Removal Step

The method for forming a germanium compound layer of the present invention may include after step 2 a step of removing unnecessary layers such as a tin-silicon-germanium sintered compact layer (Sn-Si-Ge sintered compact layer), an aluminum-tin-germanium sintered compact layer (Al-Sn-Ge sintered compact layer), and an aluminum-tin-silicon-germanium sintered compact layer (Al-Sn-Si-Ge sintered compact layer) formed on the germanium compound layer in step 2.

The method for removing unnecessary layers is not particularly limited. Unnecessary layers may be removed by a conventionally known method. Example of such methods include etching with an acid or an alkali; polishing with a coated abrasive; and polishing with silicon oxide abrasive grains, aluminum oxide abrasive grains, diamond abrasive grains, etc.

### Examples

The following describes the present invention in detail with reference to Examples and Comparative Examples. However, the present invention is not limited to the Examples.

In the Examples and Comparative Examples, the following starting materials were used.
- Tin powder: manufactured by Fujifilm Wako Pure Chemical Corporation; powder with a tin content of 99.9 mass% and an average particle size of 13 µm
- Aluminum powder: manufactured by Toyo Aluminum K.K.; spherical powder with an aluminum content of 99.9 mass% and an average particle size of 4 µm
- Silicon powder: manufactured by Fujifilm Wako Pure Chemical Corporation; powder with a silicon content of 99.99 mass% and an average particle size of 10 µm
- Aluminum-silicon alloy powder: manufactured by Toyo Aluminum K.K; spherical particle powder with a ratio of aluminum to silicon (aluminum: silicon) being 70:30 (mass ratio) and an average particle size of 6 µm
- Germanium powder: Ge Powder (manufactured by Furuuchi Chemical Corporation; non-spherical powder with a germanium content of 99.999 mass% and an average particle size of 10 um)
- Resin component: ethyl cellulose resin (manufactured by The Dow Chemical Company)
- Glass powder: manufactured by AGC Inc.; boric acid glass powder with an average particle size of 1 µm
- Organic solvent: diethylene glycol monobutyl ether

### Example 1

100 parts by mass of a tin powder, 4400 parts by mass of a silicon powder, and 10000 parts by mass of an aluminum powder were prepared. Per 100 parts by mass of tin, aluminum, and silicon in total, 23 parts by mass of diethylene glycol monobutyl ether as an organic solvent, 3 parts by mass of a glass powder, and 3 parts by mass of a resin component were prepared and mixed to prepare a paste composition.

The prepared paste composition was applied by screen printing onto a germanium wafer with a thickness of 500 um and a size of 2 cm × 2 cm so as to give an amount of 7 mg/cm² by weight before drying. Subsequently, firing was performed under the conditions of preheating at 500°C for at least 30 seconds and firing at 880°C for 10 seconds, followed by cooling to room temperature to prepare a substrate. The fired substrate was fractured to obtain the cross-section. The cross-section was observed with a scanning electron microscope (SEM) and an energy dispersive X-ray spectroscope (EDS) (JEOL Ltd., model number: JSM -6510). A mapping image showing the distribution of the germanium element and the silicon element was obtained by element mapping.

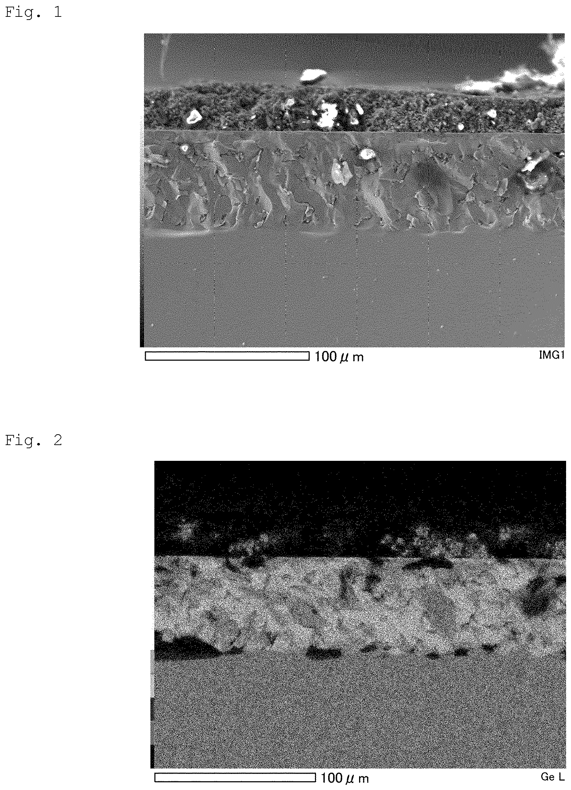

Table 1 and Figs. 1 to 3 show the results. Table 1 shows the evaluation of the formation of a germanium compound layer according to the following evaluation criteria based on the observation with an SEM and an EDS.
A: A germanium compound layer was formed with a sufficient and uniform thickness.
B: Although a germanium compound layer was formed, the germanium compound layer was thin with an uneven thickness.
C: No germanium compound layer was formed.

The evaluation found that tin, aluminum, silicon, and germanium underwent reaction to form a silicon-tin-germanium layer uniformly with a film thickness of 59 to 62 um in an area of 200 um in the width direction in an arbitrary field of view.

### Example 2

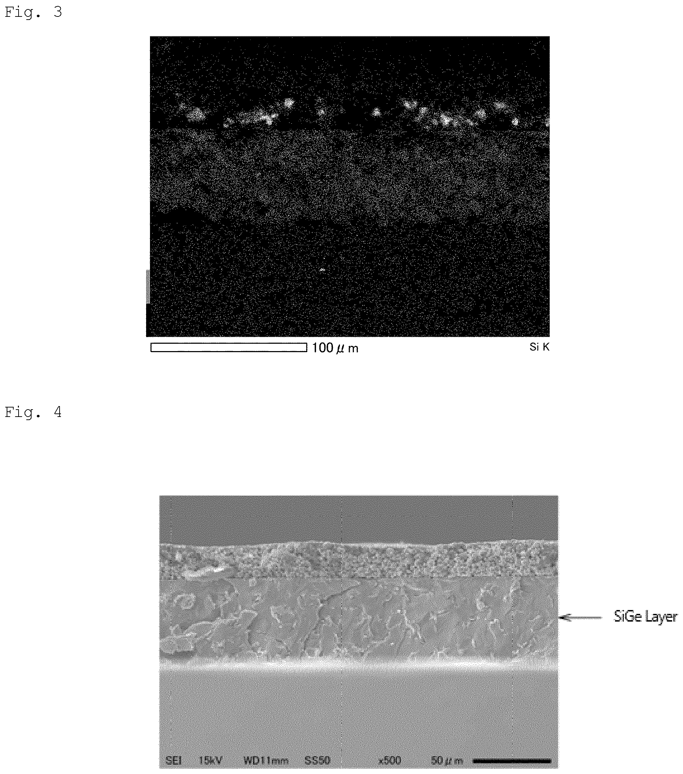

An aluminum-silicon-tin alloy powder containing 100 parts by mass of tin, 4400 parts by mass of silicon, and 10000 parts by mass of aluminum was prepared. A paste composition was prepared in the same manner as in Example 1 except for the above, and a substrate was prepared and observed by SEM. Table 1 and Fig. 4 show the results.

The evaluation found that tin, aluminum, silicon, and germanium underwent reaction to form a silicon-germanium layer uniformly with a film thickness of 53 to 55 um in an area of 200 um in the width direction in an arbitrary field of view.

### Example 3

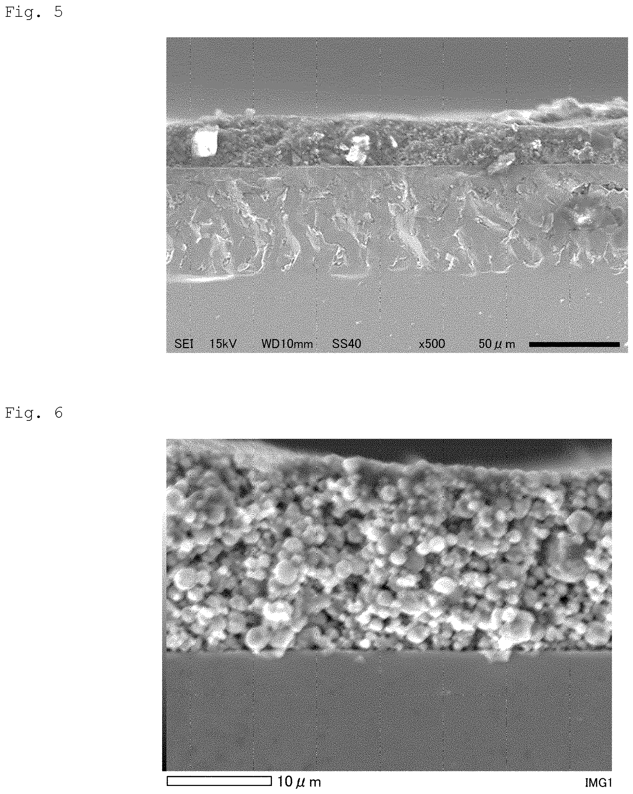

100 parts by mass of a tin powder, 10000 parts by mass of a silicon powder, and 4200 parts by mass of an aluminum powder were prepared. A paste composition was prepared in the same manner as in Example 1 except for the above, and a substrate was prepared and observed by SEM. Table 1 and Fig. 5 show the results.

The evaluation found that tin, aluminum, silicon, and germanium underwent reaction to form a silicon-germanium layer uniformly with a film thickness of 57 to 58 um in an area of 200 um in the width direction in an arbitrary field of view.

### Example 4

100 parts by mass of a tin powder, 100 parts by mass of a silicon powder, and 10000 parts by mass of an aluminum powder were prepared. A paste composition was prepared in the same manner as in Example 1 except for the above, and a substrate was prepared and observed by SEM. Table 1 shows the results.

The evaluation found that tin, aluminum, silicon, and germanium underwent reaction to form a silicon-germanium layer uniformly with a film thickness of 57 to 58 um in an area of 200 um in the width direction in an arbitrary field of view.

### Example 5

100 parts by mass of a tin powder, 10000 parts by mass of a silicon powder, and 100 parts by mass of an aluminum powder were prepared. A paste composition was prepared in the same manner as in Example 1 except for the above, and a substrate was prepared and observed by SEM. Table 1 shows the results.

The evaluation found that tin, aluminum, silicon, and germanium underwent reaction to form a silicon-germanium layer uniformly with a film thickness of 57 to 58 um in an area of 200 µm in the width direction in an arbitrary field of view.

### Example 6

100 parts by mass of a tin powder and 5000 parts by mass of an aluminum powder were prepared. A paste composition was prepared in the same manner as in Example 1 except for the above, and a substrate was prepared and observed by SEM. Table 1 shows the results.

The evaluation found that aluminum, tin, and germanium underwent reaction to form a tin-germanium layer uniformly with a film thickness of 15 to 18 um in an area of 200 um in the width direction in an arbitrary field of view.

### Example 7

100 parts by mass of a tin powder and 1 part by mass of an aluminum powder were prepared. A paste composition was prepared in the same manner as in Example 1 except for the above, and a substrate was prepared and observed by SEM. Table 1 shows the results.

The evaluation found that aluminum, tin, and germanium underwent reaction to form a tin-germanium layer uniformly with a film thickness of 10 to 14 µm in an area of 200 µm in the width direction in an arbitrary field of view.

### Example 8

100 parts by mass of a tin powder, 100 parts by mass of a silicon powder, and 100 parts by mass of an aluminum powder were prepared. A paste composition was prepared in the same manner as in Example 1 except for the above, and a substrate was prepared and observed by SEM. Table 1 shows the results.

The evaluation found that tin, silicon, aluminum, and germanium underwent reaction to form a silicon-tin-germanium layer uniformly with a film thickness of 18 to 22 um in an area of 200 um in the width direction in an arbitrary field of view.

### Example 9

100 parts by mass of a tin powder and 1 part by mass of a silicon powder were prepared. A paste composition was prepared in the same manner as in Example 1 except for the above, and a substrate was prepared and observed by SEM. Table 1 shows the results.

The evaluation found that tin, silicon, and germanium underwent reaction to form a silicon-tin-germanium layer uniformly with a film thickness of 10 to 12 um in an area of 200 um in the width direction in an arbitrary field of view.

### Example 10

100 parts by mass of a tin powder and 10000 parts by mass of an aluminum powder were prepared. A paste composition was prepared in the same manner as in Example 1 except for the above, and a substrate was prepared and observed by SEM. Table 1 shows the results.

The evaluation found that tin, aluminum, and germanium underwent reaction to form a tin-germanium layer uniformly with a film thickness of 25 to 28 um in an area of 200 µm in the width direction in an arbitrary field of view.

### Example 11

100 parts by mass of a tin powder and 10000 parts by mass of a silicon powder were prepared. A paste composition was prepared in the same manner as in Example 1 except for the above, and a substrate was prepared and observed by SEM. Table 1 shows the results.

The evaluation found that tin, silicon, and germanium underwent reaction to form a silicon-tin-germanium layer uniformly with a film thickness of 9 to 12 um in an area of 200 um in the width direction in an arbitrary field of view.

### Example 12

100 parts by mass of a tin powder, 7500 parts by mass of a silicon powder, and 7500 parts by mass of an aluminum powder were prepared. A paste composition was prepared in the same manner as in Example 1 except for the above, and a substrate was prepared and observed by SEM. Table 1 shows the results.

The evaluation found that the tin, silicon, aluminum, and germanium underwent reaction to form a silicon-tin-germanium layer uniformly with a film thickness of 30 to 33 um in an area of 200 um in the width direction in an arbitrary field of view.

### Example 13

100 parts by mass of a tin powder and 100 parts by mass of an aluminum powder were prepared. A paste composition was prepared in the same manner as in Example 1 except for the above, and a substrate was prepared and observed by SEM. Table 1 shows the results.

The evaluation found that aluminum, tin, and germanium underwent reaction to form a tin-germanium layer uniformly with a film thickness of 31 to 33 um in an area of 200 um in the width direction in an arbitrary field of view.

### Comparative Example 1

100 parts by mass of a tin powder and 0.5 parts by mass of a silicon powder were prepared. A paste composition was prepared in the same manner as in Example 1 except for the above, and a substrate was prepared and observed by SEM. Table 1 shows the results.

The evaluation found that although the germanium element moved to the sintered layer coated with the paste composition, a silicon-tin-germanium layer was not formed.

### Comparative Example 2

100 parts by mass of a tin powder and 20000 parts by mass of a silicon powder were prepared. A paste composition was prepared in the same manner as in Example 1 except for the above, and a substrate was prepared and observed by SEM. Table 1 shows the results.

The evaluation found that the paste composition did not react with the germanium substrate during firing, and that the paste composition peeled off, resulting in no formation of a silicon-germanium layer.

### Comparative Example 3

100 parts by mass of a tin powder and 0.5 parts by mass of an aluminum powder were prepared. A paste composition was prepared in the same manner as in Example 1 except for the above, and a substrate was prepared and observed by SEM. Table 1 shows the results.

The evaluation found that although the germanium element moved to the sintered layer coated with the paste composition, a tin-germanium layer was not formed.

### Comparative Example 4

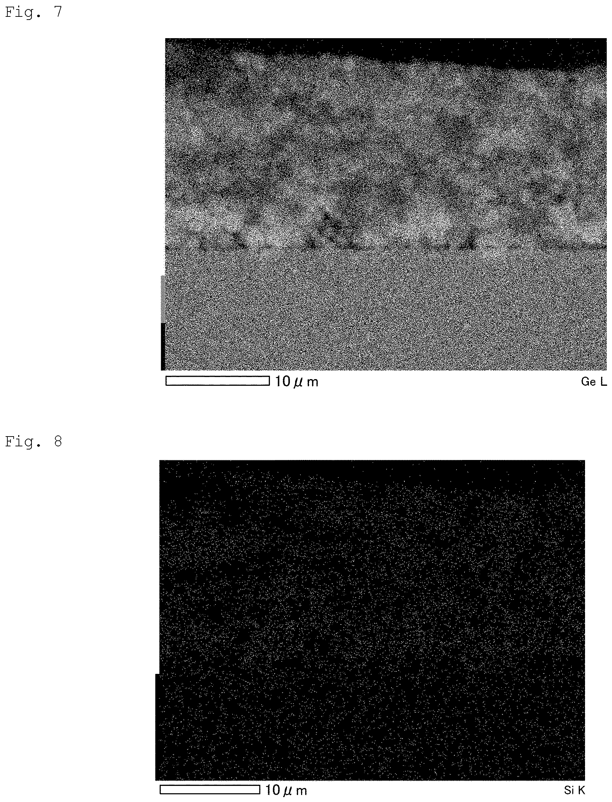

100 parts by mass of a tin powder, 100 parts by mass of a silicon powder, and 20000 parts by mass of an aluminum powder were prepared. A paste composition was prepared in the same manner as in Example 1 except for the above, and a substrate was prepared and observed by SEM. Table 1 and Figs. 6 to 8 show the results.

The evaluation found that although the germanium element moved to the sintered layer coated with the paste composition, a silicon-tin-germanium layer was not formed.

### Comparative Example 5

100 parts by mass of an aluminum powder and 47 parts by mass of a germanium powder were prepared. Per 100 parts by mass of aluminum and germanium in total, 20 parts by mass of diethylene glycol monobutyl ether as an organic solvent, 3 parts by mass of a glass powder, and 3 parts by mass of a resin component were prepared and mixed to prepare a paste composition.

The prepared paste composition was applied by screen printing onto a monocrystalline silicon wafer with a thickness of 180 um and a size of 2 cm × 2 cm so as to give an amount of 7 mg/cm² by weight before drying. In the same manner as in Example 1 except for this, a substrate was prepared and observed by SEM. Table 1 shows the results.

The evaluation found that although aluminum, silicon, and germanium underwent reaction to form a silicon-germanium layer, the formed silicon-germanium layer was thin with a thickness of 3 to 7 µm and not uniform.

**Table 1**

| | Powder | Sn (Parts by Mass) | Si (Parts by Mass) | Al (Parts by Mass) | Ge (Parts by Mass) | Formation of Ge Compound Layer |
|---|---|---|---|---|---|---|
| Example 1 | Sn Powder · Si Powder ▪ Al Powder | 100 | 4400 | 10000 | 0 | A |
| Example 2 | SnSiAl Alloy Powder | 100 | 4400 | 10000 | 0 | A |
| Example 3 | Sn Powder ▪ Si Powder ▪ Al Powder | 100 | 10000 | 4200 | 0 | A |
| Example 4 | Sn Powder ▪ Si Powder ▪ Al Powder | 100 | 100 | 10000 | 0 | A |
| Example 5 | Sn Powder ▪ Si Powder ▪ Al Powder | 100 | 10000 | 100 | 0 | A |
| Example 6 | Sn Powder ▪ Al Powder | 100 | 0 | 5000 | 0 | A |
| Example 7 | Sn Powder ▪ Al Powder | 100 | 0 | 1 | 0 | A |
| Example 8 | Sn Powder ▪ Si Powder ▪ Al Powder | 100 | 100 | 100 | 0 | A |
| Example 9 | Sn Powder ▪ Si Powder | 100 | 1 | 0 | 0 | A |
| Example 10 | Sn Powder ▪ Al Powder | 100 | 0 | 10000 | 0 | A |
| Example 11 | Sn Powder ▪ Si Powder | 100 | 10000 | 0 | 0 | A |
| Example 12 | Sn Powder ▪ Si Powder ▪ Al Powder | 100 | 7500 | 7500 | 0 | A |
| Example 13 | Sn Powder ▪ Al Powder | 100 | 0 | 100 | 0 | A |
| Comparative Example 1 | Sn Powder ▪ Si Powder | 100 | 0.5 | 0 | 0 | C |
| Comparative Example 2 | Sn Powder ▪ Si Powder | 100 | 20000 | 0 | 0 | C |
| Comparative Example 3 | Sn Powder ▪ Al Powder | 100 | 0 | 0.5 | 0 | C |
| Comparative Example 4 | Sn Powder ▪ Si Powder ▪ Al Powder | 100 | 100 | 20000 | 0 | C |
| Comparative Example 5 | Al Powder ▪ Ge Powder | 0 | 0 | 100 | 46 | B |

The above results indicate that a germanium compound layer can be formed safely and easily, and also be formed uniformly by applying the paste composition of the present invention to a germanium substrate, and heating it. Additionally, because the method for forming a germanium compound layer of the present invention allows a germanium compound layer to form by applying a paste composition to a germanium substrate and heating the paste composition, it was found that a germanium compound layer can be formed without a method using a vacuum apparatus such as CVD growth or sputtering of the related art; and that a germanium compound layer is formed safely and easily, as well as uniformly.

## Claims

1. A paste composition for forming a germanium compound layer, comprising
(A) tin, and
(B) at least one metal selected from the group consisting of silicon and aluminum,
wherein the content of the at least one metal selected from the group consisting of silicon and aluminum (B) is 1 part by mass or more and 15000 parts by mass or less, per 100 parts by mass of the tin (A).

2. The paste composition according to claim 1, wherein the content of the at least one metal selected from the group consisting of silicon and aluminum (B) is 40 parts by mass or more and 300 parts by mass or less, per 100 parts by mass of the tin (A).

3. The paste composition according to claim 1 or 2, further comprising a resin component.

4. The paste composition according to claim 3, wherein the content of the resin component is 0.1 to 10 parts by mass, per 100 parts by mass of the total amount of the tin (A) and the at least one metal selected from the group consisting of silicon and aluminum (B).

5. A method for forming a germanium compound layer, comprising
(1) step 1 of applying a paste composition to a germanium substrate, and
(2) step 2 of firing the germanium substrate coated with the paste composition, wherein
the paste composition contains (A) tin, and (B) at least one metal selected from the group consisting of silicon and aluminum, and
the content of the at least one metal selected from the group consisting of silicon and aluminum (B) is 1 part by mass or more and 15000 parts by mass or less, per 100 parts by mass of the tin (A).

6. The method according to claim 5, wherein the firing temperature in the firing is 600°C or higher and 1000°C or lower.
